(19) Europäisches Patentamt / European Patent Office / Office européen des brevets

(11) **EP 2 591 647 B1**

(12) **EUROPÄISCHE PATENTSCHRIFT**

(45) Veröffentlichungstag und Bekanntmachung des Hinweises auf die Patenterteilung:
**03.12.2014 Patentblatt 2014/49**

(51) Int Cl.:
***H05K 7/20*** *(2006.01)*

(21) Anmeldenummer: **11730634.0**

(22) Anmeldetag: **05.07.2011**

(86) Internationale Anmeldenummer:
**PCT/EP2011/061342**

(87) Internationale Veröffentlichungsnummer:
**WO 2012/004274 (12.01.2012 Gazette 2012/02)**

(54) **ELEKTRONISCHE VORRICHTUNG MIT KÜHLVORRICHTUNG**

ELECTRONIC APPARATUS WITH A COOLING APPARATUS

DISPOSITIF ÉLECTRONIQUE DOTÉ D' UN DISPOSITIF DE REFROIDISSEMENT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **07.07.2010 DE 102010026342**

(43) Veröffentlichungstag der Anmeldung:
**15.05.2013 Patentblatt 2013/20**

(73) Patentinhaber: **Rohde & Schwarz GmbH & Co. KG 81671 München (DE)**

(72) Erfinder:
- **HOLZMANN, Gottfried**
  **85604 Zorneding (DE)**
- **MITTERMAIER, Werner**
  **85435 Erding (DE)**
- **JELEN, Matthias**
  **80805 München (DE)**
- **ROTH, Martin**
  **82319 Starnberg (DE)**
- **OETJEN, Martin**
  **82194 Gröbenzell (DE)**
- **MOSER, Albert**
  **81825 München (DE)**
- **MAHR, Roland**
  **83026 Rosenheim (DE)**

(74) Vertreter: **Beder, Jens**
**Mitscherlich PartmbB**
**Patent- und Rechtsanwälte**
**Sonnenstraße 33**
**80331 München (DE)**

(56) Entgegenhaltungen:
GB-A- 2 402 816      US-B1- 6 330 153
US-B1- 6 330 155     US-B1- 6 826 456

EP 2 591 647 B1

**Beschreibung**

Die Erfindung betrifft eine elektronische Vorrichtung aufweisend eine Mehrzahl an elektronischen Baugruppen mit einer Kühlvorrichtung zum Kühlen der elektronischen Baugruppen und ein Verfahren zum Kühlen elektronischer Baugruppen.

Die elektronischen Baugruppen elektronischer Vorrichtungen erhitzen sich im Betrieb und müssen gekühlt werden. Dies wird in elektronischen Geräten normalerweise durch einen Lüfter erreicht. Es ist bekannt, für jede Baugruppe, die voraussichtliche mittlere Lebensdauer zu berechnen und die Verteilung der Kühlleistung konstruktiv und unveränderbar daran anzupassen. Der Ausfall der elektronischen Vorrichtung ist durch den ersten Ausfall einer elektronischen Baugruppe bestimmt. Deshalb wird die Kühlleistung, die relativ zu jeder Baugruppe zugeführt wird, entsprechend der Empfindlichkeit und der voraussichtlichen Belastung der einzelnen Baugruppen berechnet. Wird in einer elektronischen Vorrichtung allerdings eine elektronische Baugruppe übermäßig beansprucht, so ist die statisch zugeteilte Kühlleistung der anderen Baugruppen für ein solches Benutzungsverhalten überdimensioniert und für die stark beanspruchte Baugruppe unterdimensioniert.

Die Druckschrift US 6,330,153 B1 zeigt ein System zur Kühlung für eine elektronische Vorrichtung. Das Kühlsystem zeigt einen Kanal, gekoppelt mit einem einen Kühlluftstrom erzeugenden System sowie eine Wärmesenke. Der Kanal weist eine Vielzahl von Verengungen jeweils in der Nähe von jeweils einer zu kühlenden elektronischen Vorrichtung auf. Ein Ventil zur Steuerung des Luftstroms durch die Wärmesenke und das den Kühlluftstrom erzeugende System wird mittels eines Systemkontrollers gesteuert.

Die Druckschrift GB 2 402 816 A offenbart ein luftgekühltes Computersystem, bei dem ein kühlender Luftstrom innerhalb eines Gehäuses des Computers erzeugt wird, und das zumindest eine Luftleitvorrichtung aufweist, die zwischen einer ersten und einer zweiten Stellung verstellbar ist, um einen Luftstrom innerhalb des Gehäuses anzupassen. Ein Stellglied steuert die zumindest eine verstellbare Luftleitvorrichtung entsprechend einer Nutzereingabe, entsprechend einem Signal einer Prozessoreinheit oder eines Sensors. Der Sensor ist darauf ausgelegt, mindestens ein kennzeichnende Größe des kühlenden Luftstroms aufzunehmen.

Die Patentschrift US 6,826,456 B1 zeigt ein System und ein Verfahren zur Steuerung der Lüfter eines Servergehäuses. Hierzu werden die ermittelten Temperaturen einer Vielzahl von Temperatursensoren, die mit einzelnen Leiterkarten des Servers verbunden sind, erfasst. Die Geschwindigkeit der einzelnen Lüfter wird entsprechend der gemessenen Temperaturen im Verhältnis zu festgelegten maximalen und minimalen Temperaturen gesteuert.

Die Patentschrift US 6,330,155 B1 offenbart eine Gehäuse für eine elektronische Baugruppe, bei der eine Vielzahl von einzelnen Leiterplatten in Reihen paralleler Steckplätze mit dazwischenliegenden Luftströmungskanälen angeordnet ist. Jeder Luftströmungskanal wird mit einem Luftstrom konstanten Drucks an einem Einlass beaufschlagt und weist eine thermisch empfindliche Strömungssperre an seinem Ausgang auf. Damit ist jeder der Luftströmungskanäle hinsichtlich seiner Kühlleistung einzeln steuerbar.

Bei programmierbaren Bauteilen ist es teilweise nicht möglich, einen voraussichtlichen Kühlbedarf zu berechnen, da die Wärmeentwicklung von der Software des programmierbaren Bauteils abhängt.

Die Aufgabe der Erfindung ist es, die Nachteile des Stands der Technik zu beseitigen und eine elektronische Vorrichtung zu schaffen, deren Kühlvorrichtung geeignet ist, elektronische Baugruppen für jedes Benutzerverhalten angemessen zu kühlen.

Die Aufgabe ist durch die erfindungsgemäße elektronische Vorrichtung nach Anspruch 1 und das erfindungsgemäße Verfahren zum Kühlen von elektronischen Baugruppen nach Anspruch 9 gelöst.

Die erfindungsgemäße elektronische Vorrichtung weist eine Mehrzahl an elektronischen Baugruppen und eine Kühlvorrichtung zum Kühlen der elektronischen Baugruppen auf. Die elektronische Vorrichtung weist weiterhin Temperaturerfassungsmittel für jede Baugruppe zur Erfassung einer Temperatur, die in der jeweiligen Baugruppe herrscht, auf. Die elektronische Vorrichtung weist eine Belastungsbestimmungsvorrichtung zur Bestimmung einer Kenngröße für jede Baugruppe, die die von einer Baugruppe erfahrene Belastung beschreibt. Die Kenngröße der jeweiligen Baugruppe wird auf der Basis der erfassten Temperatur dieser Baugruppe bestimmt. Die Kühlvorrichtung weist eine Kühlleistungsverteilungsvorrichtung auf, die geeignet ist, eine (Gesamt-)Kühlleistung der Kühlvorrichtung auf die Baugruppen zu verteilen. Eine Steuervorrichtung der elektronischen Vorrichtung ist geeignet, die Kühlleistung auf die Baugruppen auf der Basis der bestimmten Kenngrößen der Baugruppen mittels Steuerung der Kühlleistungsverteilungsvorrichtung zu verteilen.

Das erfindungsgemäße Verfahren zum Kühlen einer Mehrzahl elektronischer Baugruppen weist die folgenden Schritte auf: Zuerst wird eine Temperatur individuell für jede Baugruppe erfasst. Aus jeder Temperatur einer der Baugruppen wird eine Kenngröße für die zu der Temperatur gehörende Baugruppe bestimmt, wobei die Kenngröße jeder Baugruppe die von dieser Baugruppe erfahrene Belastung angibt. Die Kenngröße wird auf der Basis der erfassten Temperatur dieser Baugruppe bestimmt. Daraufhin wird eine Kühlleistung auf die Baugruppen auf der Basis der bestimmten Kenngrößen der Baugruppen verteilt.

Die Temperatur der elektronischen Baugruppen ist die bestimmende Größe für die Belastung der elektronischen Bauteile, vor allem für deren Halbleiterbauteile. Durch die individuelle Erfassung der Temperatur jeder einzelnen Baugruppe kann die Belastung für jede Baugruppe einzeln berechnet werden und jeweils in einer Kenngröße ausgedrückt werden. Die Erfindung hat nun den Vorteil, dass die Kühlleistung der einzelnen Baugruppen adaptiv während des normalen Betriebs automatisch an unvorhergesehene Belastungen bzw. Änderungen der Belastungen der Baugruppen angepasst werden kann und somit die Gesamtbelastung der elektronischen Vorrichtung reduziert wird. Die Verteilung der Kühlleistung auf die einzelnen Baugruppen der erfindungsgemäßen elektronischen Vorrichtung wird somit für jedes Benutzerverhalten optimal angepasst.

Erfindungsgemäß ist die Kenngröße jeder Baugruppe die geschätzte Restlebenszeit dieser Baugruppe. Als Restlebenszeit einer Baugruppe oder einer Vorrichtung wird in Zusammenhang mit der beschriebenen Erfindung die verbleibende Zeit der Baugruppe oder der Vorrichtung bezeichnet, bis diese das nächste Mal ausfällt. Die mittlere Restlebenszeit einer Baugruppe kann aus der mittleren Zeit zwischen zwei Ausfällen ("Mean Time Between Failure", MTBF) und der erfahrenen Betriebszeit der Baugruppe berechnet werden, wobei die MTBF aus der erfassten Temperatur der Baugruppe berechnet werden kann. Die Restlebenszeit ist als Kenngröße besonders vorteilhaft, weil es die für den nächsten Ausfall der Baugruppe wichtigste Kenngröße ist und sowohl für den Steueralgorithmus als auch für einen Benutzer besonders aussagekräftig ist. Zur Beschreibung wird generell auf den Ausfall einer Baugruppe Bezug genommen. Anstelle der Zeit bis zum Ausfall kann jedoch ebenso eine Zeit bis zum nächsten Wartungstermin (z.B. Rekalibrierung) betrachtet werden.

Die abhängigen Ansprüche betreffen vorteilhafte Weiterführungen der Erfindung.

Es ist insbesondere vorteilhaft, dass die Belastungsbestimmungsvorrichtung geeignet ist, die Kenngröße jeder Baugruppe basierend auf einer Einwirkungszeit der erfassten Temperatur auf diese Baugruppe zu bestimmen, die aus dem Temperaturverlauf der Baugruppe bestimmt wird. Dadurch kann die Kenngröße der Belastung besonders genau bestimmt werden, da die Betriebszeit der Baugruppe zusammen mit einer Temperaturbewertung dieser Betriebszeit in die Kenngrößenberechnung eingeht. Somit kann der gesamte erfahrene Temperaturverlauf, d.h. zumindest der während der Betriebszeit der Baugruppe erfahrene Temperaturverlauf einer Baugruppe für die Berechnung der Kenngröße für die Belastung dieser Baugruppe berücksichtigt werden.

Es ist vorteilhaft, dass die elektronische Vorrichtung eine Eingabevorrichtung zum Einlesen von Benutzerinteraktionen aufweist. Diese ist mit der Steuervorrichtung verbunden. Die Steuervorrichtung ist so ausgebildet, dass der Temperaturverlauf einer der Baugruppen in Folge einer bestimmter eingelesenen Benutzerinteraktion gelöscht wird. Dadurch ist es einem Benutzer möglich, den Temperaturverlauf einer Baugruppe zu löschen, wenn diese z.B. ausgetauscht oder gewartet wurde. Dadurch kann auch die adaptive Kühlung auch nach einem Baugruppenaustausch verbessert werden.

Es ist ebenso von Vorteil, dass die Belastungsbestimmungsvorrichtung geeignet ist, die Kenngröße jeder Baugruppe in periodischen Abständen erneut zu bestimmen und die Steuervorrichtung geeignet ist, die die Verteilung der Kühlleistung auf die Baugruppen auf der Basis der erneut bestimmten Kenngrößen der Baugruppen anzupassen. Durch die periodische Neubestimmung der Belastung der lässt sich die Kenngröße für die Belastung der einzelnen Baugruppen aktuell halten und die eingestellte Kühlleistung für jede Baugruppe wird jederzeit auf der Basis der erfahrenen Belastung aktualisiert.

Es ist weiterhin vorteilhaft, die geschätzte Restlebenszeit jeder Baugruppe durch die Berücksichtigung der für diese Baugruppe eingestellten Kühlleistung und der damit einhergehenden voraussichtlichen zukünftigen Wärmeentwicklung zu verbessern. Dadurch kann die Genauigkeit der geschätzten Restlebenszeit weiter verbessert werden und somit ein früher Ausfall der elektronischen Vorrichtung durch den Ausfall einer Baugruppe noch besser vermieden werden.

Es ist besonders vorteilhaft, die Kühlleistung für jede Baugruppe so zu steuern, dass die aus den abgeschätzten Restlebenszeiten der Baugruppen berechnete Restlebenszeit der elektronischen Vorrichtung maximal wird.

Ein weiterer Vorteil ergibt sich durch das Ausgeben der ermittelten Kenngrößen der Belastungen der einzelnen Baugruppen. Dadurch ist es möglich, dem Benutzer des Geräts oder einem Servicemitarbeiter, der die elektronische Vorrichtung wartet, den Verschleiß und die Belastung der einzelnen Baugruppen und/oder die mittlere Restlebenszeit der einzelnen Baugruppen mitzuteilen. So kann ein überbeanspruchtes Bauteil frühzeitig ersetzt werden und somit die auf Kosten der Kühlleistung für die übrigen Baugruppen erhöhte Kühlleistung für das ersetzte Bauteil wieder reduziert werden. Damit kann die Gesamtlebensdauer des Geräts weiter erhöht werden, da dem Benutzer oder dem Servicemitarbeiter eine spezifische ausfallgefährdete Baugruppe mitgeteilt wird und diese frühzeitig ersetzt werden kann, bevor die veränderte Kühlleistung ebenfalls die Restlebenszeit der anderen Baugruppen verkürzt.

In Bezug auf die Erfindung wird unter der Verteilung der Kühlleistung jede Steuerung der Kühlleistung für die einzelnen Baugruppen verstanden, die die Kühlleistung für wenigstens eine dieser Baugruppen im Verhältnis zu den Kühlleistungen der anderen Baugruppen verändern kann. Die Gesamtkühlleistung kann aber dabei nicht notwendigerweise konstant sein. Allerdings ist die Erfindung besonders interessant für eine maximale Gesamtkühlleistung.

Zwei bevorzugte Ausführungsbeispiele der Erfindung werden nachfolgend anhand der Zeichnung beschrieben. Die Zeichnung zeigt:

Fig. 1 eine schematische Darstellung eines ersten Ausführungsbeispiels der erfindungsgemäßen elektronischen Vorrichtung;

Fig. 2 eine schematische Darstellung eines zweiten Ausführungsbeispiels der erfindungsgemäßen elektronischen Vorrichtung; und

Fig. 3 ein Verfahrensdiagramm mit den Schritten des erfindungsgemäßen Verfahrens zum Kühlen elektronischer Baugruppen.

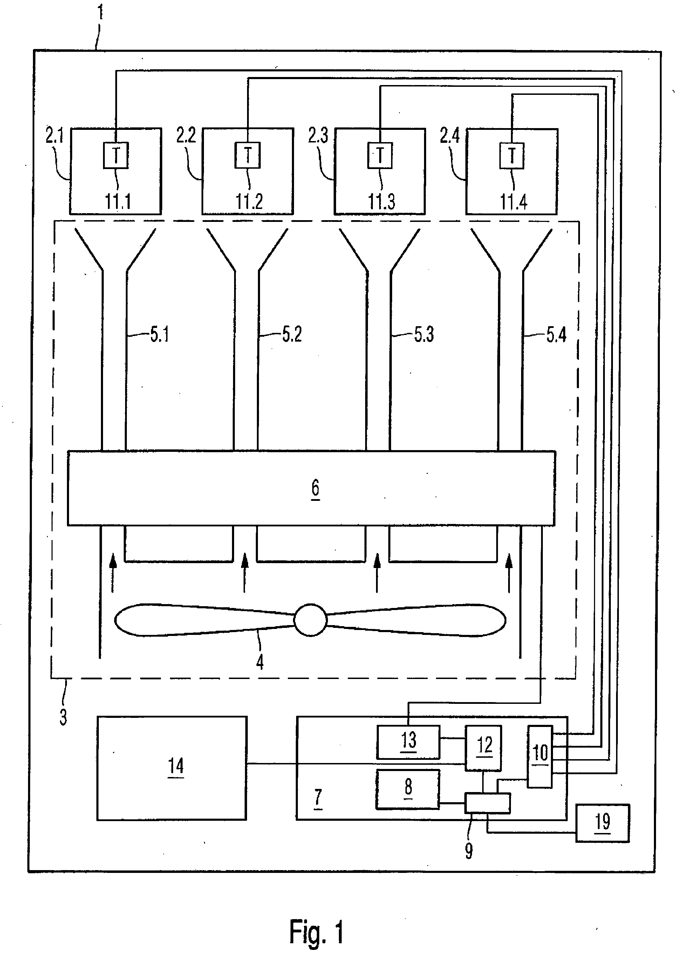

Fig. 1 zeigt ein erstes Ausführungsbeispiel der erfindungsgemäßen elektronischen Vorrichtung. Das elektronische Gerät 1 als elektronische Vorrichtung weist vier elektronische Baugruppen 2.1, 2.2, 2.3 und 2.4 als Mehrzahl elektronischer Baugruppen auf. Die Erfindung ist nicht beschränkt auf vier elektronische Baugruppen 2.1 bis 2.4, sondern ist für jede Anzahl ≥2 zu kühlender elektronischer Baugruppen geeignet. Die Baugruppen können dabei gleich oder verschieden aufgebaut sein. Eine elektronische Baugruppe ist normalerweise aus einer Mehrzahl verbundener elektronischer Bauteile aufgebaut, so dass diese Baugruppe zumindest eine Funktion in dem Gerät 1 erfüllt. Allerdings kann eine Baugruppe auch aus nur einem elektronischen Bauteil bestehen. In diesem Ausführungsbeispiel weisen die Baugruppen 2.1 bis 2.4 Halbleiter aus Galliumarsenid (GaAs) als elektronische Bauteile auf, die besonders temperatursensibel sind und deren verbleibende Lebensdauer sehr stark von der erfahrenen Temperatur abhängt.

Das Gerät 1 weist weiterhin eine Kühlvorrichtung 3 auf. Die Kühlvorrichtung 3 weist einen Ventilator 4 und Luftstromzuführungen 5.1, 5.2, 5.3 und 5.4, die jeweils zu genau einer entsprechenden Baugruppe 2.1, 2.2, 2.3 und 2.4 führen, auf. Die Luftstromzuführungen 5.1 bis 5.4 können wie in der Fig. 1 schematisch angedeutet aus Rohren oder anderweitigen Luftstromzuführungen bestehen, die jeweils gegenüber den anderen Luftstromzuführungen abgeschlossen sind. Der Ventilator 4 saugt von außen Luft an und führt diese über die Luftstromzuführungen 5.1 bis 5.4 den elektronischen Baugruppen 2.1. bis 2.4 zu. Alternativ ist es auch möglich, dass der Ventilator 4 die erwärmte Luft der Baugruppen 2.1 bis 2.4 über die Luftstromzuführungen 5.1 bis 5.4 ansaugt. Die Gesamtkühlleistung der Kühlvorrichtung 3 ist somit durch die Leistung des Ventilators 4 und die Temperatur der angesaugten Luft begrenzt. Die Kühlvorrichtung 3 weist weiterhin ein Klappensystem 6 als Kühlleistungsverteilungsvorrichtung zum einzelnen auch teilweisen Öffnen und Schließen der Luftstromzuführungen 5.1 bis 5.4 auf. Klappensystem 6 verteilt die Gesamtluftstrommenge des Ventilators 4 als Gesamtkühlleistung durch den Öffnungsgrad der einzelnen Luftzuführungen 5.1 bis 5.4 relativ auf die einzelnen Baugruppen 2.1 bis 2.4. Der Öffnungsgrad einer Luftzuführung 5.1 bis 5.4 wird durch den Öffnungsgrad einer Klappe in der jeweiligen Luftzuführung 5.1 bis 5.4 realisiert. Jede der vier Klappen der vier Luftzuführungen 5.1 bis 5.4 ist individuell durch einen Servomotor ansteuerbar. Somit kann der Öffnungsgrad jeder Luftzuführung 5.1 bis 5.4 individuell angesteuert werden. Alternativ können die Klappen auch magnetisch gesteuert werden.

Das Gerät 1 wird durch eine Steuervorrichtung 7 kontrolliert. Die Steuervorrichtung 7 steuert auf der Basis von Benutzereingaben die einzelnen Baugruppen 2.1 bis 2.4 an. Die Steuerverbindung zwischen der Steuervorrichtung 7 und den einzelnen Baugruppen 2.1 bis 2.4 ist zur Vereinfachung der Fig. 1 nicht gezeigt. Die Steuervorrichtung 7 weist einen Betriebsstundenzähler 8 als Betriebsdauerbestimmungsvorrichtung auf. Der Betriebsstundenzähler 8 misst für jede Baugruppe 2.1 bis 2.4 eine Betriebsdauer, welche die Zeitdauer angibt, in welcher sich die jeweilige Baugruppe 2.1 bis 2.4 in Betrieb befand. Die jeweilige Betriebsdauer der einzelnen Baugruppen 2.1 bis 2.4 wird in einem Speicher 9 gespeichert und während des Betriebs des Geräts 1 regelmäßig von dem Betriebsstundenzähler 8 aktualisiert. Die Informationen, ob eine Baugruppe 2.1 bis 2.4 im Betrieb ist, erhält der Betriebsstundenzähler 8 von der Steuervorrichtung 7, welche die Baugruppen 2.1 bis 2.4 steuert.

Eine Temperaturermittlungseinheit 10 und Temperatursensoren 11.1 bis 11.4 bilden eine Temperaturerfassungsvorrichtung. Die Temperatureinheit 10 ist mit den Temperatursensoren 11.1 bis 11.4 in den Baugruppen 2.1 bis 2.4 verbunden. Jede Baugruppe 2.1 bis 2.4 weist jeweils einen Temperatursensor 11.1 bis 11.4 auf, welcher die aktuelle Temperatur dieser Baugruppe 2.1 bis 2.4 an die Temperaturermittlungseinheit 10 gibt. Die Temperaturermittlungseinheit 10 speichert die Temperaturverläufe der einzelnen Baugruppen 2.1 bis 2.4 in dem Speicher 9 und aktualisiert diese regelmäßig während des Betriebs des Geräts 1. Der Temperaturverlauf einer der Baugruppen 2.1 bis 2.4 besteht aus der Temperatur dieser Baugruppen 2.1 bis 2.4 über die Betriebsdauer seit dem ersten Einschalten der Baugruppe. Die Betriebsdauer ist dabei eine relative Zeit die nur während des Betriebs der Baugruppe 2.1 bis 2.4 nach oben oder unten zählt. Der Temperaturverlauf wird aufgenommen und in dem Speicher 9 gespeichert oder aktualisiert. So kann z.B. für jede Betriebssekunde eine gemessene Temperatur gespeichert werden. Alternativ könnte der Temperaturverlauf einer der Baugruppen 2.1 bis 2.4 aus den gemessenen Temperaturen mit den den Temperaturen zugeordneten absoluten Messzeitpunkten bestehen. Der Temperaturverlauf wird dann für die ganze Betriebszeit mit einer bestimmten Abtastrate aufgenommen und in dem Speicher 9 gespeichert. Alternativ kann die Temperatur der einzelnen Baugruppen 2.1 bis 2.4 auch ohne Temperatursensoren 11.1 bis 11.4 in einer alternativen Temperaturerfassungsvorrichtung, z.B. durch eine rechnerische Temperaturbestimmung anhand der Ansteuerströme und -spannungen und der enthaltenen Bauteile, erfasst werden. Dies könnte z.B. durch eine vorher bestimmte Kennlinie oder Kennmatrix der Eingangsparameter, der eingestellten Kühlleistung und der gemessenen Temperatur geschehen. Hier kann auch eine gemessene gemeinsame Außentemperatur mit einfließen.

Eine Restlebensdauerermittlung 12 als Belastungsbestimmungsvörrichtung der Steuervorrichtung 7 berechnet auf der Basis der Betriebsdauer und des Temperaturverlaufs einer Baugruppe 2.1 bis 2.4 die Restlebenszeit dieser Baugruppe der Baugruppen 2.1 bis 2.4. Im Folgenden wird im Zusammenhang mit der Baugruppe 2.1 die Berechnung der Restlebenszeit der Baugruppe 2.1 beschrieben, welche ohne Beschränkung der Erfindung auch auf die Restlebenszeiten der anderen Baugruppen 2.2 bis 2.4 Anwendung findet. Zuerst wird die MTBF der Baugruppe 2.1 aus dem in dem Speicher 9 enthaltenen Temperaturverlauf der Baugruppe 2.1 berechnet. In dem Ausführungsbeispiel ist MTBF der Baugruppe 2.1 durch die MTBF des GaAs-Halbleiters in der Baugruppe bestimmt, da der Halbleiter 2.1 die höchste Ausfallrate aufweist. Die MTBF(T1) einer Baugruppe bei einer Betriebstemperatur von T1

$$MTBF(T1) = MTBF(T0) \cdot e^{\frac{E}{k}(\frac{1}{T1} - \frac{1}{T0})}$$

wird aus der bekannten MTBF(T0) bei einer Referenztemperatur T0 berechnet. Die Referenztemperatur kann z.B. die Zimmertemperatur sein. MTBF(T0) kann empirisch ermittelt werden oder kann berechnet werden. E ist dabei die Aktivierungsenergie eines GaAs-Halbleiters, die zwischen 1,2 eV und 1,9 eV liegt, und k ist die Boltzmankonstante. Da die Baugruppe während der Betriebszeit verschiedenen Temperaturen ausgesetzt wird und die Temperaturen nicht linear in die MTBF eingehen, wird der Gesamttemperaturbereich, dem die Baugruppe 2.1 ausgesetzt war, in eine Anzahl N von gleich großen Temperaturbereichen mit jeweils einer mittleren Temperatur $T_i$ mit i=1, ..., N unterteilt. Aus dem Temperaturverlauf der Baugruppe 2.1 wird ermittelt, welche Zeitdauer $t_i$ die Baugruppe 2.1 Temperaturen des Temperaturbereichs mit der mittleren Temperatur $T_i$ ausgesetzt war. Dies wird für alle N Temperaturbereiche bestimmt. Normiert man die Zeitdauern $t_i$, so dass die Summe aller $t_i$ eins entspricht, so erhält man die relative Anteil $n_i$ der bisherigen Gesamtbetriebsdauer der Baugruppe 2.1, in welcher die Baugruppe 2.1 Temperaturen des Temperaturbereichs mit der mittleren Temperatur $T_i$ ausgesetzt war. Die MTBF der Baugruppe 2.1 ergibt sich nun zu

$$MTBF_{2.1} = \sum_{i=1}^{N} n_i \cdot MTBF(T_i)$$

aus der Summe der mit $n_i$ gewichteten $MTBF(T_i)$. Für die Berechnung sind weitere Daten in dem Speicher 9 enthalten. Relevante Daten für die Abschätzung der Restlebenszeit als Kenngröße der Belastung einer Baugruppe können die enthaltenen Bauteile, die unterschiedlich temperaturempfindlich sind und unterschiedliche Lebensdauern aufweisen, und die Berechnungsmethode für die enthaltenen Bauteile bzw. für die Gesamtbaugruppe 2.1 sein.

In einem alternativen Ausführungsbeispiel kann die $MTBF_{2.1}$ weiter verbessert werden, indem die eingestellte Kühlleistung und die damit verbundene voraussichtliche zukünftige Temperaturentwicklung bei ähnlicher Benutzung der Baugruppe 2.1 wie in der Vergangenheit bei der Berechnung der $MTBF_{2.1}$ berücksichtigt wird. Weiterhin kann die Abschätzung der mittleren Restlebenszeit der einzelnen Baugruppen 2.1 bis 2.4 berücksichtigen, ob ein Bauteil 2.1 bis 2.4 gerade ausgetauscht wurde und somit neu ist. Neue Bauteile haben zu Beginn eine höhere Ausfallwahrscheinlichkeit. Dies könnte durch einen reduzierenden Neuheitsfaktor bei der MTBF-Berechnung in der Belastungsbestimmungsvorrichtung berücksichtigt werden, indem die MTBF der neuen Baugruppe mit dem Neuheitsfaktor multipliziert wird. Ein solcher Neuheitsfaktor kann in der Belastungsbestimmungsvorrichtung für die ersten Betriebsstunden der neuen Baugruppe Anwendung finden. In einem besonders einfachen weiteren alternativen Ausführungsbeispiel könnte die MTBF auch aus einer gemittelten Temperatur des Temperaturverlaufs der Baugruppe 2.1 berechnet werden. Dies ist zwar nicht so genau, da die Nichtlinearität des Einflusses der Temperatur nicht berücksichtigt wird, ergibt aber zumindest ein qualitativ richtiges Ergebnis, wobei eine geringere Rechenkapazität in der Steuervorrichtung 7 benötigt wird. Aus der MTBF lässt sich nach Abzug der erfahrenen Betriebsdauer der Baugruppe 2.1 die mittlere Restlebenszeit der Baugruppe 2.1 berechnen, d.h. die Restlebenszeit der Baugruppe 2.1 abschätzen.

Die abgeschätzten Restlebenszeiten der einzelnen Baugruppen 2.1 bis 2.4 werden an eine Kühlleistungsregelung 13 gegeben. Die Kühlleistungsregelung 13 berechnet aus den Restlebenszeiten der einzelnen elektronischen Baugruppen 2.1 bis 2.4 den jeweiligen Öffnungsgrad der Luftzuführungen 5.1 bis 5.4 der jeweiligen Baugruppen 2.1 bis 2.4 und geben die Öffnungsgrade der einzelnen Luftstromzuführungen 5.1 bis 5.4 an das Klappensystem 6 weiter. Das Klappensystem 6 steuert die Klappen der Luftstromzuführungen 5.1 bis 5.4 nach der Maßgabe der von der Kühlleistungsregelung 13 berechneten Öffnungsgrade der Luftstromzuführungen 5.1 bis 5.4. Die Kühlleistungsregelung 13 berechnet dabei die Öffnungsgrade der Luftstromzuführungen 5.1 bis 5.4 so, dass die Restlebenszeit des Geräts 1 maximiert wird. Da die Restlebenszeit des Geräts 1 durch die kleinste Restlebenszeit der Baugruppen 2.1 bis 2.4 bestimmt ist, ist es besonders vorteilhaft, die Öffnungsgrade der Luftstromzuführungen 5.1 bis 5.4 so zu berechnen, dass sich die Restlebenszeiten der einzelnen Baugruppen 2.1 bis 2.4 angleichen oder zumindest die kleinste Restlebenszeit der Baugruppen 2.1 bis 2.4 erhöht wird. Dazu werden in der Kühlleistungsregelung 13 die Klappen des Klappensystems 6, die die Kühlleistung der Baugruppen steuert, die eine kleiner Restlebensdauer als die mittlere Restlebensdauer aller Baugruppen haben, um einen Öffnungsschritt geöffnet und/oder die restlichen Klappen oder wenigstens ein Teil davon um einen Öffnungsschritt geschlossen. Ein Öffnungsschritt ist eine vorher festgelegte kleinste Änderung der Kühlleistung für eine Baugruppe 2.1 bis 2.4. In dem ersten Ausführungsbeispiel entspricht dies einer Änderung der Klappenöffnung der Luftzuführung 5.1 bis 5.4. Die Restlebensdauer der Baugruppen wird in regelmäßigen Zeitabständen berechnet. Sollten Baugruppen weiterhin eine niedrigere Restlebenszeit als die mittlere Restlebenszeit haben, werden die Klappen dieser Baugruppen um einen weiteren Öffnungsschritt geöffnet und/oder die den übrigen Baugruppen zugeordneten Klappen um einen weiteren Öffnungsschritt geschlossen. Passen sich die Restlebenszeiten der Baugruppen an die mittlere Restlebenszeit an, werden die Klappenöffnungen konstant gehalten. So kann die Verteilung der Kühlleistung auf die Baugruppen individuell an die Benutzung der Baugruppen durch den Benutzer angepasst werden und die Lebenszeit des Geräts 1 maximiert werden.

Bei der Kühlleistungsregelung 13 werden die Anschläge, d.h. den maximalen Öffnungs- und Schließwinkel der Klappe der Luftstromzuführung 5.1 bis 5.7, bei der Regelung berücksichtigt. Weiterhin wird bei der Steuerung berücksichtigt, dass auch den Baugruppen 2.1 bis 2.4, die eine höhere Restlebensdauer als die gemittelte Restlebensdauer aller Baugruppen 2.1 bis 2.4 aufweisen, zumindest so viel Kühlleistung zugeteilt wird, dass diese Baugruppen unterhalb einer Maximaltemperatur bleiben. Dadurch wird eine überproportionale Kühlung auf Kosten von anderen Baugruppen aufgrund der Überschreitung einer Maximaltemperatur verhindert. Große Unterschiede zwischen den Restlebenszeiten der einzelnen Baugruppen 2.1 bis 2.4 können nach dem Austausch einer Baugruppe 2.1 bis 2.4 durch eine neue entstehen.

Die Restlebenszeitbestimmung 12 gibt die berechneten Restlebenszeiten ebenfalls an eine Ausgabevorrichtung 14. Die Ausgabevorrichtung 14 kann z.B. aus einem Bildschirm oder einer Schnittstelle bestehen, die von den Benutzern oder von für Wartungsarbeiten verantwortlichen Personen abgerufen werden können. So können hochbelastete Baugruppen frühzeitig erkannt werden und vor dem Ausfall der Baugruppe prophylaktisch ausgetauscht werden, sodass der überraschende Ausfall des Geräts 1 vermieden wird. Durch die adaptive Anpassung der Kühlleistung der einzelnen Baugruppen auf der Basis der Restlebenszeit dieser Baugruppen, kann die Gesamtlebensdauer des Geräts 1 für jede Art der Benutzung der einzelnen Baugruppen 2.1 bis 2.4 maximiert werden.

Weiterhin weist das Gerät 1 eine Eingabevorrichtung 19 auf, über die ein Benutzer oder eine Wartungsperson in dem Speicher 9 der Steuervorrichtung 7 ablegen kann, dass eine bestimmte Baugruppe ausgetauscht wurde. In Folge eines solchen Austauschs einer Baugruppe wird der alte Temperaturverlauf dieser Baugruppe gelöscht und ein neuer erstellt. Weiterhin wird der Betriebsstundenzähler 8 für diese Baugruppe auf Null zurückgesetzt. Eine solche Eingabevorrichtung 19 ermöglicht es, auch nach einem Austausch einer Baugruppe eine korrekte individuell angepasste Kühlleistungssteuerung zu gewährleisten.

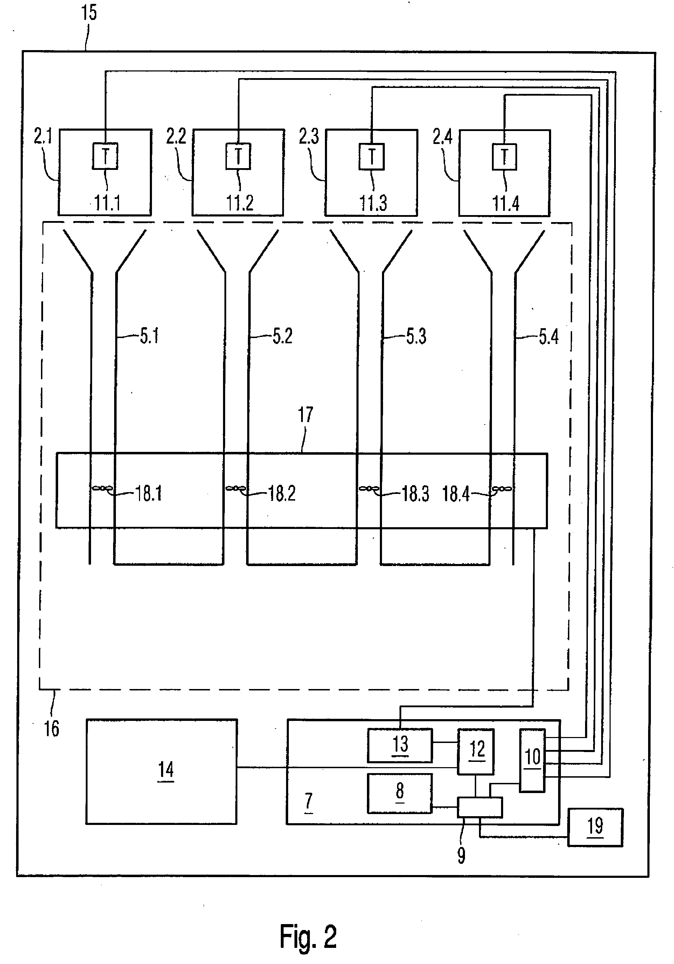

Fig. 2 zeigt ein alternatives Ausführungsbeispiel der erfindungsgemäßen elektronischen Vorrichtung. Das Gerät 15 ist wie das Gerät 1 aufgebaut. Gleiche Vorrichtungen des Geräts 15 werden deshalb mit gleichen Referenzzeichen bezeichnet und nicht erneut beschrieben. Die Kühlvorrichtung 16 unterscheidet sich von der Kühlvorrichtung 3 dadurch, dass die Kühlleistung für die einzelnen Baugruppen 2.1 bis 2.4 in der Kühlleistungsverteilungsvorrichtung 17 durch vier einzelne Ventilatoren 18.1 bis 18.4 einzeln erzeugt wird. Jeder Ventilator 18.1 bis 18.4 erzeugt die Kühlleistung für eine Baugruppe 2.1 bis 2.4. Die Kühlleistungsverteilungsvorrichtung 17 verteilt entsprechend der Kühlleistungsregelvorrichtung 13 die elektrisch zur Verfügung stehende Kühlleistung auf die vier Ventilatoren 18.1 bis 18.4. Alternativ können die Ventilatoren 18.1 bis 18.4 direkt an den Baugruppen angeordnet sein. Anstatt einer festen Gesamtluftstrommenge als Gesamtkühlleistung auf die einzelnen Baugruppen 2.1 bis 2.4 zu verteilen wie in dem ersten Ausführungsbeispiel wird in dem zweiten Ausführungsbeispiel die elektrische Gesamtkühlleistung auf die vier Ventilatoren 18.1 bis 18.4 aufgeteilt.

Die Erfindung ist ebenfalls nicht auf Luftkühlung beschränkt, sondern kann ebenfalls durch die Regelung einer Zuführung eines anderen Kühlmittels, wie Wasser, realisiert werden. Die Erfindung bedarf also einer Kühlvorrichtung, welche die Kühlleistung für die einzelnen Baugruppen 2.1 bis 2.4 individuell steuern kann. Dies kann durch die Gesamtkühlleistung und deren anteilige Verteilung auf die einzelnen Baugruppen 2.1 bis 2.4 geregelt werden.

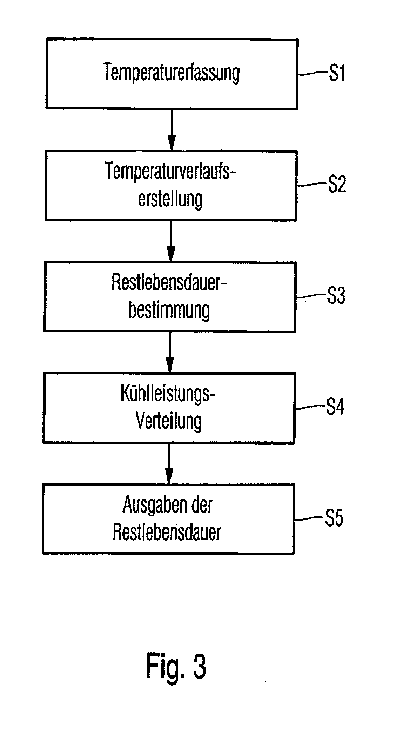

Fig. 3 zeigt die Schritte des erfindungsgemäßen Verfahrens zum Kühlen einer Anzahl an elektronischen Baugruppen 2.1 bis 2.4. In Schritt S1 wird die Temperatur jeder Baugruppe erfasst und in Schritt S2 ein Temperaturverlauf für jede Baugruppe 2.1 bis 2.4 aus der erfassten Temperatur erzeugt oder ergänzt. Aus dem Temperaturverlauf wird in einem dritten Schritt S3, wie oben beschrieben, eine Restlebenszeit für jede Baugruppe 2.1 bis 2.4 geschätzt. Auf der Basis der geschätzten Restlebenszeiten der Baugruppen 2.1 bis 2.4 wird in Schritt S4 die Kühlleistung für jede Baugruppe 2.1 bis 2.4 einzeln so eingestellt oder verteilt, dass die Gesamtrestlebensdauer aller Baugruppen 2.1 bis 2.4 maximiert wird. Optional kann in Schritt S5 die berechnete unterschiedliche mittlere Restlebensdauer für jede Baugruppe 2.1 bis 2.4 an einen Bildschirm oder eine Schnittstelle ausgegeben werden.

Kann eine Funktion für die Restlebenszeit $t_{Rest}$ in Abhängigkeit der Kühlleistungen der vier Baugruppen 2.1 bis 2.4 aufgestellt werden, kann durch die Maximierung dieser Funktion in Abhängigkeit der Kühlleistungsverteilung eine optimale Kühlleistungsverteilung erzeugt werden.

Alternativ ist es in dem ersten und zweiten Ausführungsbeispiel auch möglich, als Kenngröße für die Belastung der einzelnen Baugruppen 2.1 bis 2.4 nicht die Restlebenszeit zu verwenden. Eine Alternative wäre z.B. die Betriebszeit eines Bauteils mit der erfahrenen Temperatur zu gewichten, z.B. durch Integration des normierten Temperaturverlaufs der Baugruppe über die Betriebszeit. Wird der Temperaturverlauf unterhalb einer vorbestimmten, nicht mehr belastenden Temperatur für die Baugruppe auf 0 gesetzt, kann die Betriebszeit direkt aus dem Temperaturverlauf ermittelt werden. Alternativ könnte die Temperatur nur oberhalb einer für die Baugruppe schädigenden und deren Lebenszeit verkürzenden Temperatur berücksichtigt werden oder nur die Maximaltemperatur einer Baugruppe eingehen.

Die Erfindung ist nicht auf die hier beschriebenen Ausführungsbeispiele beschränkt. Vielmehr können alle Alternativen vorteilhaft miteinander kombiniert werden.

**Patentansprüche**

1. Elektronische Vorrichtung aufweisend
   eine Mehrzahl an elektronischen Baugruppen (2.1, 2.2, 2.3, 2.4) und eine Kühlvorrichtung (3, 16) zum Kühlen der elektronischen Baugruppen; jeweils ein Temperaturerfassungsmittel (10, 11.1, 11.2, 11.3, 11.4) für jede Baugruppe zur individuellen Erfassung einer Temperatur jeder Baugruppe (2.1, 2.2, 2.3, 2.4);
   eine Belastungsbestimmungsvorrichtung (12) zur Bestimmung einer Kenngröße für jede Baugruppe (2.1, 2.2, 2.3, 2.4), die die von einer Baugruppe (2.1, 2.2, 2.3, 2.4) erfahrene Belastung beschreibt, auf der Basis der erfassten Temperatur dieser Baugruppe (2.1, 2.2, 2.3, 2.4);
   eine Kühlleistungsverteilungsvorrichtung (6, 17) zur Verteilung einer Kühlleistung der Kühlvorrichtung (3, 16) auf die Baugruppen (2.1, 2.2, 2.3, 2.4); und
   eine Steuervorrichtung (7) zur Steuerung der Verteilung mittels der Kühlleistungsverteilungsvorrichtung (6, 17) auf der Basis der bestimmten Kenngrößen der Baugruppen (2.1, 2.2, 2.3, 2.4),
   **gekennzeichnet dadurch**
   **dass** die Kenngröße jeder Baugruppe (2.1, 2.2, 2.3, 2.4) die geschätzte Restlebenszeit dieser Baugruppe (2.1, 2.2, 2.3, 2.4) ist.

2. Vorrichtung nach Anspruch 1,
   **dadurch gekennzeichnet,**
   **dass** die Belastungsbestimmungsvorrichtung (12) geeignet ist, die Kenngröße jeder Baugruppe (2.1, 2.2, 2.3, 2.4) basierend auf dem erfahrenen Temperaturverlauf dieser Baugruppe (2.1, 2.2, 2.3, 2.4) zu bestimmen.

3. Vorrichtung nach Anspruch 2,
   **gekennzeichnet durch**
   eine Eingabevorrichtung (19) zum Einlesen von Benutzerinteraktionen verbunden mit der Steuervorrichtung (7), wobei die Steuervorrichtung (7) so ausgebildet ist, dass der Temperaturverlauf einer der Baugruppen (2.1, 2.2, 2.3, 2.4) in Folge einer bestimmter eingelesenen Benutzerinteraktion gelöscht wird.

4. Vorrichtung nach einem der Ansprüche 1 bis 3,
   **dadurch gekennzeichnet,**
   **dass** die Belastungsbestimmungsvorrichtung (12) geeignet ist, die Kenngröße jeder Baugruppe (2.1, 2.2, 2.3, 2.4) in periodischen Abständen erneut zu bestimmen und
   die Steuervorrichtung (7) geeignet ist, die Kühlleistungsverteilungsvorrichtung (6, 17) so zu steuern, dass die Kühlleistung auf der Basis der erneut bestimmten Kenngröße der Baugruppen (2.1, 2.2, 2.3, 2.4) auf die Baugruppen (2.1, 2.2, 2.3, 2.4) verteilt wird.

5. Vorrichtung nach Anspruch 4,
   **dadurch gekennzeichnet,**
   **dass** die Belastungsbestimmungsvorrichtung (12) geeignet ist, die Restlebenszeit jeder Baugruppe (2.1, 2.2, 2.3, 2.4) auf der Basis der eingestellten Kühlleistung dieser Baugruppe (2.1, 2.2, 2.3, 2.4) abzuschätzen.

6. Vorrichtung nach Anspruch 4 oder 5,
   **dadurch gekennzeichnet,**
   **dass** die Steuervorrichtung (7) geeignet ist, die Kühlleistungsverteilungsvorrichtung (6, 17) so zu steuern, dass die Kühlleistung auf die Baugruppen (2.1, 2.2, 2.3, 2.4) verteilt wird, dass die aus den Restlebenszeiten der Baugruppen (2.1, 2.2, 2.3, 2.4) bestimmte Restlebenszeit der elektronischen Vorrichtung (1, 15) maximal wird.

7. Vorrichtung nach einem der Ansprüche 1 bis 6,
   **dadurch gekennzeichnet**,
   eine Ausgabevorrichtung (14) zum Ausgeben der Kenngrößen der einzelnen Baugruppen (2.1, 2.2, 2.3, 2.4).

8. Verfahren zum Kühlen einer Mehrzahl an elektronischen Baugruppen (2.1, 2.2, 2.3, 2.4);
   mit den folgenden Schritten:

   - Ermitteln jeweils einer Temperatur jeder Baugruppe (S1, S2);
   - Ermitteln einer Kenngröße für jede Baugruppe (2.1, 2.2, 2.3, 2.4), die die von einer Baugruppe (2.1, 2.2, 2.3, 2.4) erfahrene Belastung beschreibt, auf der Basis der erfassten Temperatur dieser Baugruppe (2.1, 2.2, 2.3, 2.4) (S3); und

- Steuern einer Verteilung einer Kühlleistung auf die Baugruppen (2.1, 2.2, 2.3, 2.4) auf der Basis der bestimmten Kenngrößen der Baugruppen (2.1, 2.2, 2.3, 2.4) (S4),

**dadurch gekennzeichnet,**
**dass** als Kenngröße jeder Baugruppe (2.1, 2.2, 2.3, 2.4) die Restlebenszeit dieser Baugruppe (2.1, 2.2, 2.3, 2.4) geschätzt wird.

9. Verfahren nach Anspruch 8,
**dadurch gekennzeichnet,**
**dass** die Kenngröße jeder Baugruppe (2.1, 2.2, 2.3, 2.4) basierend auf dem erfahrenen Temperaturverlauf dieser Baugruppe (2.1, 2.2, 2.3, 2.4) bestimmt wird.

10. Verfahren nach Anspruch 8 oder 9,
**dadurch gekennzeichnet,**
**dass** die Kenngröße jeder Baugruppe (2.1, 2.2, 2.3, 2.4) in periodischen Abständen erneut bestimmt wird und die Verteilung der Kühlleistung auf die Baugruppen (2.1, 2.2, 2.3, 2.4) auf der Basis der erneut bestimmten Kenngröße dieser Baugruppe (2.1, 2.2, 2.3, 2.4) gesteuert wird.

11. Verfahren nach Anspruch 10,
**dadurch gekennzeichnet,**
**dass** die Restlebenszeit jeder Baugruppe (2.1, 2.2, 2.3, 2.4) unter Berücksichtigung der eingestellten Kühlleistung dieser Baugruppe (2.1, 2.2, 2.3, 2.4) bestimmt wird.

12. Verfahren nach Anspruch 10 oder 11,
**dadurch gekennzeichnet,**
**dass** die Kühlleistung für jede Baugruppe (2.1, 2.2, 2.3, 2.4) so gesteuert wird, dass die aus den Restlebenszeiten der Baugruppen (2.1, 2.2, 2.3, 2.4) bestimmte Restlebenszeit der elektronischen Vorrichtung (1, 15) maximal wird.

13. Verfahren nach einem der Ansprüche 7 bis 11,
**gekennzeichnet durch**
Ausgeben der Kenngrößen der einzelnen Baugruppen (2.1, 2.2, 2.3, 2.4) (S5).

**Claims**

1. Electronic apparatus having
a plurality of electronic assemblies (2.1, 2.2, 2.3, 2.4) and a cooling apparatus (3, 16) for cooling the electronic assemblies; a respective temperature sensing means (10, 11.1, 11.2, 11.3, 11.4) for each assembly for individually sensing a temperature for each assembly (2.1, 2.2, 2.3, 2.4);
a load determination apparatus (12) for determining a characteristic quantity for each assembly (2.1, 2.2, 2.3, 2.4), which describes the load experienced by an assembly (2.1, 2.2, 2.3, 2.4), on the basis of the sensed temperature of this assembly (2.1, 2.2, 2.3, 2.4);
a cooling power distribution apparatus (6, 17) for distributing a cooling power of the cooling apparatus (3, 16) to the assemblies (2.1, 2.2, 2.3, 2.4); and
a control apparatus (7) for controlling the distribution by means of the cooling power distribution apparatus (6, 17) on the basis of the determined characteristic quantities of the assemblies (2.1, 2.2, 2.3, 2.4),
**characterized**
**in that** the characteristic quantity of each assembly (2.1, 2.2, 2.3, 2.4) is the estimated remaining life of this assembly (2.1, 2.2, 2.3, 2.4).

2. Apparatus according to Claim 1,
**characterized**
**in that** the load determination apparatus (12) is suited to determining the characteristic quantity of each assembly (2.1, 2.2, 2.3, 2.4) on the basis of the temperature profile experienced for this assembly (2.1, 2.2, 2.3, 2.4).

3. Apparatus according to Claim 2,
**characterized by**
an input apparatus (19) for reading in user interactions connected to the control apparatus (7), wherein the control apparatus (7) is designed such that the temperature profile of one the assemblies (2.1, 2.2, 2.3, 2.4) is erased as a result of a particular user interaction that has been read in.

4. Apparatus according to one of Claims 1 to 3,
**characterized**
**in that** the load determination apparatus (12) is suited to re-determining the characteristic quantity of each assembly (2.1, 2.2, 2.3, 2.4) at periodic intervals, and
the control apparatus (7) is suited to controlling the cooling power distribution apparatus (6, 17) such that the cooling power is distributed to the assemblies (2.1, 2.2, 2.3, 2.4) on the basis of the re-determined characteristic quantity of the assemblies (2.1, 2.2, 2.3, 2.4).

5. Apparatus according to Claim 4,
**characterized**
**in that** the load determination apparatus (12) is suited to estimating the remaining life of each assembly (2.1, 2.2, 2.3, 2.4) on the basis of the set cooling power of this assembly (2.1, 2.2, 2.3, 2.4).

6. Apparatus according to Claim 4 or 5,
**characterized**
**in that** the control apparatus (7) is suited to controlling the cooling power distribution apparatus (6, 17) such that the cooling power is distributed to the assemblies (2.1, 2.2, 2.3, 2.4) such that the remaining life of the electronic apparatus (1, 15) as determined from the remaining lives of the assemblies (2.1, 2.2, 2.3, 2.4) is maximized.

**7.** Apparatus according to one of Claims 1 to 6, **characterized**
**by** an output apparatus (14) for outputting the characteristic quantities of the individual assemblies (2.1, 2.2, 2.3, 2.4).

**8.** Method for cooling a plurality of electronic assemblies (2.1, 2.2, 2.3, 2.4);
having the following steps:

- a respective temperature of each assembly is ascertained (S1, S2);
- a characteristic quantity for each assembly (2.1, 2.2, 2.3, 2.4), which describes the load experienced by an assembly (2.1, 2.2, 2.3, 2.4), is ascertained on the basis of the sensed temperature of this assembly (2.1, 2.2, 2.3, 2.4) (S3); and
- distribution of a cooling power to the assemblies (2.1, 2.2, 2.3, 2.4) is controlled on the basis of the determined characteristic quantities of the assemblies (2.1, 2.2, 2.3, 2.4) (S4),

**characterized**
**in that** the characteristic quantity estimated for each assembly (2.1, 2.2, 2.3, 2.4) is the remaining life of this assembly (2.1, 2.2, 2.3, 2.4).

**9.** Method according to Claim 8,
**characterized**
**in that** the characteristic quantity of each assembly (2.1, 2.2, 2.3, 2.4) is determined on the basis of the temperature profile experienced for this assembly (2.1, 2.2, 2.3, 2.4).

**10.** Method according to Claim 8 or 9,
**characterized**
**in that** the characteristic quantity of each assembly (2.1, 2.2, 2.3, 2.4) is re-determined at periodic intervals and the distribution of the cooling power to the assemblies (2.1, 2.2, 2.3, 2.4) is controlled on the basis of the re-determined characteristic quantity of this assembly (2.1, 2.2, 2.3, 2.4).

**11.** Method according to Claim 10,
**characterized**
**in that** the remaining life of each assembly (2.1, 2.2, 2.3, 2.4) is determined by taking account of the set cooling power of this assembly (2.1, 2.2, 2.3, 2.4).

**12.** Method according to Claim 10 or 11,
**characterized**
**in that** the cooling power for each assembly (2.1, 2.2, 2.3, 2.4) is controlled such that the remaining life of the electronic apparatus (1, 15) as determined from the remaining lives of the assemblies (2.1, 2.2, 2.3, 2.4) is maximized.

**13.** Method according to one of Claims 7 to 11,
**characterized by**
the characteristic quantities of the individual assemblies (2.1, 2.2, 2.3, 2.4) being output (S5).

**Revendications**

**1.** Dispositif électronique comportant
une pluralité de modules électroniques (2.1, 2.2, 2.3, 2.4) et un dispositif de refroidissement (3, 16) pour refroidir les modules électroniques ; un moyen de détection de température respective (10, 11.1, 11.2, 11.3, 11.4) pour chaque module en vue de la détection individuelle d'une température de chaque module (2.1, 2.2, 2.3, 2.4) ;
un dispositif de détermination de charge (12) pour déterminer un paramètre pour chaque module (2.1, 2.2, 2.3, 2.4), qui décrit la charge subie par un module (2.1, 2.2, 2.3, 2.4), en fonction de la température détectée de ce module (2.1, 2.2, 2.3, 2.4) ;
le dispositif de répartition de capacité de refroidissement (6, 17) pour répartir une capacité de refroidissement du dispositif de refroidissement (3, 16) sur les modules (2.1, 2.2, 2.3, 2.4) ; et
un dispositif de commande (7) pour commander la répartition au moyen du dispositif de répartition de capacité de refroidissement (6, 17) en fonction des paramètres déterminés des modules (2.1, 2.2, 2.3, 2.4), **caractérisé en ce que**
le paramètre de chaque module (2.1, 2.2, 2.3, 2.4) est la durée de vie restante estimée de ce module (2.1, 2.2, 2.3, 2.4).

**2.** Dispositif selon la revendication 1, **caractérisé en ce que**
le dispositif de détermination de charge (12) est adapté pour déterminer le paramètre de chaque module (2.1, 2.2, 2.3, 2.4) en fonction de la courbe de température subie de ce module (2.1, 2.2, 2.3, 2.4).

**3.** Dispositif selon la revendication 2, **caractérisé par**
un dispositif de saisie (19) en vue d'entrer les interactions d'utilisateur relié avec le dispositif de commande (7), dans lequel le dispositif de commande (7) est réalisé de sorte que la courbe de température d'un des modules (2.1, 2.2, 2.3, 2.4) est effacée à la suite d'une interaction d'utilisateur entrée déterminée.

**4.** Dispositif selon l'une des revendications 1 à 3, **caractérisé en ce que**
le dispositif de détermination de charge (12) est adapté pour déterminer de nouveau le paramètre de chaque module (2.1, 2.2, 2.3, 2.4) à des intervalles périodiques et

le dispositif de commande (7) est adapté pour commander le dispositif de répartition de capacité de refroidissement (6, 17) de sorte que la capacité de refroidissement est répartie sur les modules (2.1, 2.2, 2.3, 2.4) en fonction du paramètre à nouveau déterminé des modules (2.1, 2.2, 2.3, 2.4).

5. Dispositif selon la revendication 4, **caractérisé en ce que**

le dispositif de détermination de charge (12) est adapté pour évaluer la durée de vie restante de chaque module (2.1, 2.2, 2.3, 2.4) en fonction de la capacité de refroidissement réglée de ce module (2.1, 2.2, 2.3, 2.4).

6. Dispositif selon la revendication 4 ou 5, **caractérisé en ce que** le dispositif de commande (7) est adapté pour commander le dispositif de répartition de capacité de refroidissement (6, 17) de sorte que la capacité de refroidissement est répartie sur les modules (2.1, 2.2, 2.3, 2.4), de sorte que la durée de vie restante du dispositif électronique (1, 15) déterminée à partir des durées de vie restantes des modules (2.1, 2.2, 2.3, 2.4) est maximale.

7. Dispositif selon l'une des revendications 1 à 6, **caractérisé par**

un dispositif de sortie (14) pour délivrer les paramètres des différents modules (2.1, 2.2, 2.3, 2.4).

8. Procédé pour refroidir une pluralité de modules électroniques (2.1, 2.2, 2.3, 2.4) ;

comportant les étapes suivantes :

   - détecter une température respective de chaque module (S1, S2) ;
   - détecter un paramètre pour chaque module (2.1, 2.2, 2.3, 2.4), qui décrit la charge subie par un module (2.1, 2.2, 2.3, 2.4), en fonction de la température détectée de ce module (2.1, 2.2, 2.3, 2.4) (S3) ; et
   - commander une répartition d'une capacité de refroidissement sur les modules (2.1, 2.2, 2.3, 2.4) en fonction des paramètres déterminés des modules (2.1, 2.2, 2.3, 2.4) (S4),

   **caractérisé en ce que**
   la durée de vie restante de ce module (2.1, 2.2, 2.3, 2.4) est évaluée en tant que paramètre de chaque module (2.1, 2.2, 2.3, 2.4).

9. Procédé selon la revendication 8, **caractérisé en ce que**

le paramètre de chaque module (2.1, 2.2, 2.3, 2.4) est déterminé en fonction de la courbe de température subie de ce module (2.1, 2.2, 2.3, 2.4).

10. Procédé selon la revendication 8 ou 9, **caractérisé en ce que**

le paramètre de chaque module (2.1, 2.2, 2.3, 2.4) est de nouveau déterminé à des intervalles périodiques et la répartition de la capacité de refroidissement sur les modules (2.1, 2.2, 2.3, 2.4) est commandée en fonction du paramètre à nouveau déterminé de ce module (2.1, 2.2, 2.3, 2.4).

11. Procédé selon la revendication 10, **caractérisé en ce que**

la durée de vie restante de ce module (2.1, 2.2, 2.3, 2.4) est déterminée en considérant la capacité de refroidissement réglée de ce module (2.1, 2.2, 2.3, 2.4).

12. Procédé selon la revendication 10 ou 11, **caractérisé en ce que**

la capacité de refroidissement pour chaque module (2.1, 2.2, 2.3, 2.4) est commandée de sorte que la durée de vie restante du dispositif électronique (1, 15) déterminée à partir des durées de vie restantes des modules (2.1, 2.2, 2.3, 2.4) est maximale.

13. Procédé selon l'une des revendications 7 à 11, **caractérisé par**

la délivrance des paramètres des différents modules (2.1, 2.2, 2.3, 2.4) (S5).

Fig. 1

Fig. 2

```
┌─────────────────────────┐
│   Temperaturerfassung   │──S1
└─────────────────────────┘
             │
             ▼
┌─────────────────────────┐
│   Temperaturverlaufs-   │──S2
│       erstellung        │
└─────────────────────────┘
             │
             ▼
┌─────────────────────────┐
│   Restlebensdauer-      │──S3
│       bestimmung        │
└─────────────────────────┘
             │
             ▼
┌─────────────────────────┐
│   Kühlleistungs-        │──S4
│       Verteilung        │
└─────────────────────────┘
             │
             ▼
┌─────────────────────────┐
│   Ausgaben der          │──S5
│   Restlebensdauer       │
└─────────────────────────┘
```

## Fig. 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6330153 B1
- GB 2402816 A
- US 6826456 B1
- US 6330155 B1